# EUROPEAN PATENT APPLICATION

(11) **EP 4 668 054 A2**
(43) Date of publication of application: **24.12.2025**
(21) Application number: 25182955.2
(22) Date of filing: 16.06.2025
(51) Int. Cl.: G06F 1/20, H01L 23/367, H01L 23/473, H05K 7/20

(54) **LIQUID COOLING ASSEMBLY, COMPUTING AND LIQUID COOLING UNIT, AND SUPERCOMPUTING SERVER**

(30) Priority: 18.06.2024 CN 202421394885 U
(71) Applicant: Bitdeer Semiconductor Technology PTE. LTD., 049514 Singapore (SG)
(72) Inventor: YANG, SENFENG, 049514 Singapore (SG); LI, WEIGUO, 049514 Singapore (SG); DAI, QIANG, 049514 Singapore (SG)
(74) Representative: Metida

(57) **Abstract**

Disclosed are a liquid cooling assembly, a computing and liquid cooling unit, and a supercomputing server. The liquid cooling assembly is applicable to the supercomputing server and includes a bottom shell and a top plate. The bottom shell includes a base plate, a sidewall, at least one flow channel dividing wall, and a plurality of heat dissipation fins. The sidewall is disposed on an upper surface of the base plate and is arranged in an annular shape, forming a flow channel for a coolant within the annular shape. The flow channel dividing wall is disposed within the sidewall, wherein one end of the flow channel dividing wall is connected to the sidewall, and another end of the flow channel dividing wall is not in contact with any part of the sidewall. The flow channel dividing wall divides the flow channel into a plurality of communicated sub-flow channels. The plurality of heat dissipation fins are distributed within each of the sub-flow channels. The top plate is fitted onto an upper surface of the sidewall facing away from the base plate, completely enclosing the flow channel. A surface of each of the heat dissipation fins facing away from the base plate is in contact with the top plate. The present disclosure achieves efficient production, easy assembly, and excellent heat dissipation performance.

## Description

### TECHNICAL FIELD

The present disclosure relates to the technical field of liquid cooling, and in particular, relates to a liquid cooling assembly, a computing and liquid cooling unit, and a supercomputing server.

### BACKGROUND

Liquid cooling methods are commonly applied in high-performance computing electronic devices, such as supercomputing servers. To meet the demands for high computing power, these electronic devices typically integrate multiple hash boards (computing boards or compute boards). Each hash board houses multiple high-performance chips. The cumulative heat generated by these high-performance chips during operation is considerable. Consequently, liquid cooling assemblies, positioned in close contact with the hash boards, are utilized to achieve efficient heat dissipation.

With the ever-increasing market demands for liquid cooling assemblies designed for high-performance computing electronic devices, there is an urgent need for a liquid cooling assembly that is efficiently manufacturable, easy to assemble, and reliable in operation.

### SUMMARY

Accordingly, the present disclosure is mainly intended to provide a liquid cooling assembly, a computing and liquid cooling unit, and a supercomputing server.

In a first aspect, embodiments of the present disclosure provide a liquid cooling assembly, applicable to a supercomputing server, the supercomputing server including a hash board and the liquid cooling assembly, the hash board including a plurality of chip strip groups; wherein the liquid cooling assembly includes a bottom shell and a top plate; wherein
the bottom shell includes a base plate, a sidewall, at least one flow channel dividing wall, and a plurality of heat dissipation fins; wherein
the sidewall is disposed on an upper surface of the base plate and is arranged in an annular shape, forming a flow channel for a coolant within the annular shape,
the at least one flow channel dividing wall is disposed within the sidewall, wherein one end of the flow channel dividing wall is connected to the sidewall and another end of the flow channel dividing wall is not in contact with any part of the sidewall, and the flow channel dividing wall divides the flow channel into a plurality of communicated sub-flow channels,
the plurality of heat dissipation fins are distributed within each of the sub-flow channels, and
the base plate, the sidewall, the flow channel dividing wall, and the heat dissipation fins are integrally formed; and
the top plate is fitted onto an upper surface of the sidewall facing away from the base plate, completely enclosing the flow channel, and a surface of each of the heat dissipation fins facing away from the base plate is abutted against the top plate;
wherein in a case where the liquid cooling assembly is applied in the supercomputing server, the hash board is disposed in contact with the base plate or the top plate of the liquid cooling assembly, and positions of the plurality of chip strip groups on the hash board are in correspondence with a region where the flow channel is disposed within the liquid cooling assembly.

In some embodiments, a plurality of bottom rib groups are arranged on a lower surface of the base plate, wherein a number of the bottom rib groups is equal to a number of the sub-flow channels, and the plurality of bottom rib groups are arranged in one-to-one correspondence with the plurality of sub-flow channels in a thickness direction of the base plate.

In some embodiments, a plurality of top rib groups are arranged on an upper surface of the top plate, wherein a number of the top rib groups is equal to the number of the sub-flow channels and the plurality of top rib groups are arranged in one-to-one correspondence with the plurality of sub-flow channels in a thickness direction of the top plate.

In some embodiments, each of the bottom rib groups and each of the top rib groups both include three ribs; and
in each of the bottom rib groups and each of the top rib groups, spacings between adjacent ribs are equal, and a maximum distance between two ribs that are farthest apart is equal to a width of the sub-flow channel corresponding to a rib group of the two ribs.

In some embodiments, a number of the sub-flow channels is four; and in each of the sub-flow channels, five rows of heat dissipation fins are arranged, the five rows extending in a same direction as an extension direction of the sub-flow channel.

In some embodiments, within each of the sub-flow channels, a plurality of heat dissipation fin groups are spaced apart along an extension direction of the sub-flow channel.

In some embodiments, at least one positioning structure is arranged between an upper surface of the sidewall and the top plate to accurately position the top plate at a corresponding position on the upper surface of the sidewall;
wherein the positioning structure includes two positioning protrusions disposed on the upper surface of the sidewall and two positioning slots disposed at corresponding portions of the top plate.

In some embodiments, the base plate is elongated, the sidewall includes two short-side sub-sidewalls and two long-side sub-sidewalls, and both of the positioning protrusions are disposed on an upper surface of a same one of the short-side sub-sidewalls.

In some embodiments, the at least one flow channel dividing wall is juxtaposed with the long-side sub-sidewalls; and
the positioning structure further includes positioning posts and positioning holes, wherein the positioning posts are arranged on both an upper surface of each of the at least one flow channel dividing wall and on an upper surface of each of the long-side sub-sidewalls, and positioning holes corresponding to the positioning posts are arranged in the top plate.

In some embodiments, a plurality of the flow channel dividing walls are parallelly arranged, and the plurality of sub-flow channels are parallel to each other and sequentially communicated with each other.

In some embodiments, a number of the chip strip groups is equal to the number of the sub-flow channels, and each of the chip strip groups includes three chip strips;
wherein during use of the liquid cooling assembly in the supercomputing server, the chip strips are in contact with bottom ribs on the base plate in one-to-one correspondence, or are in contact with top ribs on the top plate in one-to-one correspondence.

In a second aspect, embodiments of the present disclosure provide a computing and liquid cooling unit. The computing and liquid cooling unit includes a hash board and the liquid cooling assembly as described above, wherein the hash board is disposed on an upper surface of the top plate, and/or on a lower surface of the base plate.

In a third aspect, the embodiments of the present disclosure provide a supercomputing server. The supercomputing server includes the liquid cooling assembly as described above, or the computing and liquid cooling unit as described above.

In the liquid cooling assembly according to the present disclosure, the base plate, the sidewall, the flow channel dividing walls, and the heat dissipation fins are integrally formed. Subsequently, the liquid cooling assembly is assembled by fitting the top plate over the upper surface of the sidewall facing away from the base plate. In an application scenario of heat dissipation in contact with the hash board, the liquid cooling assembly is capable of rapidly absorbing heat from the hash board through flow of the coolant within the sub-flow channels. The present disclosure, while fully ensuring the operation reliability of the liquid cooling assembly, also significantly facilitates the efficient manufacturing and assembly of the liquid cooling assembly.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic perspective structural view of a liquid cooling assembly (with a coolant inlet and a coolant outlet) according to some embodiments of the present disclosure;
FIG. 2 is a schematic perspective structural view of a top plate according to some embodiments of the present disclosure;
FIG. 3 is a schematic perspective structural view of an upper surface of a bottom shell according to some embodiments of the present disclosure;
FIG. 4 is a schematic perspective structural view of a lower surface of a bottom shell according to some embodiments of the present disclosure; and
FIG. 5 is a schematic structural cross-sectional view of a liquid cooling assembly according to some embodiments of the present disclosure.

Reference numerals and denotations thereof: 100 top plate, 110 top rib group, 111 top rib, 120 positioning slot, 130 positioning hole, 200 bottom shell, 210 bottom rib group, 211 bottom rib, 220 positioning protrusion, 230 positioning post, 240 base plate, 250 side wall, 260 flow channel dividing wall, 270 flow channel, 271 sub-flow channel, 280 heat dissipation fin, 300 coolant outlet, 400 coolant inlet.

### DESCRIPTION OF EMBODIMENTS

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

In the present disclosure, a top plate is defined as being disposed "above" a bottom shell, rather than "below." All concepts related to "above" and "below" within this document shall be understood with reference to the definition of "above."

A surface of a bottom shell facing toward the top plate is defined as its "upper surface," and a surface of the bottom shell facing away from the top plate is defined as its "lower surface."

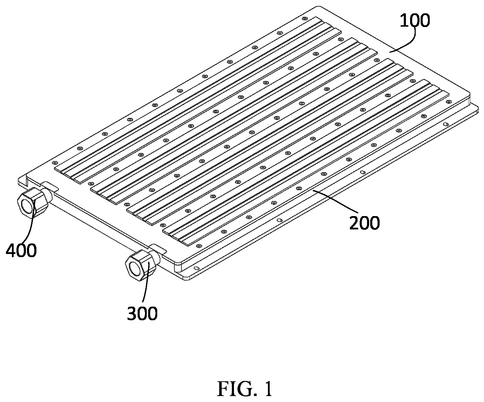

Referring to FIG. 1 to FIG. 5, some embodiments of the present disclosure provide a liquid cooling assembly, applicable to a supercomputing server. The supercomputing server includes a hash board and the liquid cooling assembly. The hash board includes a plurality of chip strip groups. The liquid cooling assembly includes a bottom shell 200 and a top plate 100.

The bottom shell 200 includes a base plate 240, a sidewall 250, at least one flow channel dividing wall 260, and a plurality of heat dissipation fins 280.

The sidewall 250 is disposed on an upper surface of the base plate 240 and is arranged in an annular shape, forming a flow channel 270 for a coolant within the annular shape.

The at least one flow channel dividing wall 260 is disposed within the sidewall 250, wherein one end of the flow channel dividing wall 260 is connected to the sidewall 250 and another end of the flow channel dividing wall 260 is not in contact with any part of the sidewall 250, and the flow channel dividing wall 260 divides the flow channel 270 into a plurality of communicated sub-flow channels 271.

The plurality of heat dissipation fins 280 are distributed within each of the sub-flow channels 271.

The base plate 240, the sidewall 250, the flow channel dividing wall 260, and the heat dissipation fins 280 are integrally formed.

The top plate 100 is fitted onto an upper surface of the sidewall 250 facing away from the base plate 240, completely enclosing the flow channel 270, and a surface of each of the heat dissipation fins 280 facing away from the base plate 240 is abutted against the top plate 100.

Specifically, the liquid cooling assembly according to the present disclosure is typically used for the heat dissipation of high-performance computing devices (i.e., supercomputing servers). In an operating state, within the supercomputing server, the liquid cooling assembly is in contact with a hash board. The liquid cooling assembly is formed by assembling the top plate 100 and the bottom shell 200 together. The flow channel 270 is arranged within the bottom shell 200, which allows the coolant to flow therein to carry away the heat generated by the hash board (which is in contact with the liquid cooling assembly) during operation. (Referring to FIG. 1, the coolant may enter through a coolant inlet 400 assembled and connected to the liquid cooling assembly, and flow out from a coolant outlet 300 assembled and connected to the liquid cooling assembly). To facilitate assembly, the top plate 100 and the bottom shell 200 may each be integrally formed. In this way, even though the bottom shell 200 includes a plurality of functional components, it is not necessary to first assemble these functional components one by one on-site before affixing the top plate, thereby effectively improving the assembly efficiency of the liquid cooling assembly.

To form the flow channel 270, the bottom shell 200 is designed to include the base plate 240 and the sidewalls 250, wherein the sidewalls 250 are disposed on an upper surface of the base plate 240 and are arranged in an annular shape. In this manner, the flow channel 270 for the coolant is formed within this annular arrangement.

Considering that a flow velocity of the coolant is also closely related to the heat dissipation efficiency, it is further designed that at least one flow channel dividing wall 260 is arranged within the sidewalls 250 of the bottom shell 200 to divide the flow channel 270 into a plurality of communicated sub-flow channels 271. Because a cross-sectional area of the sub-flow channels 271 is significantly reduced compared to that of the flow channel 270, the flow velocity of the coolant is significantly increased, thereby effectively enhancing the heat dissipation efficiency. Furthermore, the arrangement of the flow channel dividing wall 260 also contributes to increasing the contact area between the coolant and the bottom shell 200, thereby facilitating more rapid and thorough heat exchange between the coolant and the liquid cooling assembly. The flow channel dividing wall 260 may be conveniently designed and formed based on a configuration where one end of the flow channel dividing wall 260 is connected to the sidewall 250 and the other end of the flow channel dividing wall 260 is not in contact with any part of the sidewall 250. This also facilitates the molding of the relevant portions of the sidewall 250 and the flow channel dividing wall 260 during the process of integrally forming the bottom shell 200.

To further enhance the heat exchange efficiency, it is designed that heat dissipation fins 280 are arranged in each of the sub-flow channels 271. The heat dissipation fins 280 are capable of increasing the contact area between the bottom shell 200 and the coolant, which significantly improves the heat exchange efficiency. Moreover, the heat dissipation fins 280 is further capable of constricting flow of the coolant, thereby helping to further increase the flow velocity of the coolant. In this way, the cooling efficiency is further enhanced. Additionally, the heat dissipation fins 280 may also serve to enhance the structural strength of the bottom shell 200 and reduce noise generated by flow of the coolant. Moreover, when the number, shape, thickness, and length of the heat dissipation fins 280 remain substantially unchanged, a greater height of the heat dissipation fins 280 typically results in a larger contact area with the coolant. Therefore, the present disclosure is further configured such that after the top plate 100 is fitted onto the bottom shell 200, a surface of the heat dissipation fins 280 facing away from the base plate 240 is able to be in contact with the top plate 100. That is, the height of the heat dissipation fins 280 reaches the same height as the flow channel 270. This further enhances the efficiency of heat conduction and dissipation, and concurrently helps to reduce the occurrence of turbulence during flow of the coolant.

In the liquid cooling assembly according to the present disclosure, the base plate 240, the sidewall 250, the flow channel dividing walls 260, and the heat dissipation fins 280 are integrally formed. Subsequently, the liquid cooling assembly is assembled by fitting the top plate 100 over the upper surface of the sidewall 250 facing away from the base plate 240. In an application scenario of heat dissipation in contact with the hash board, the liquid cooling assembly is capable of rapidly absorbing heat from the hash board through flow of the coolant within the sub-flow channels 271. The present disclosure, while fully ensuring the operation reliability of the liquid cooling assembly, also significantly facilitates the efficient manufacturing and assembly of the liquid cooling assembly.

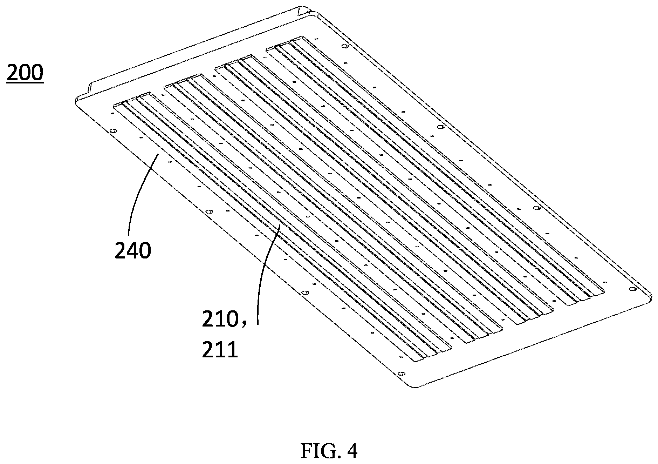

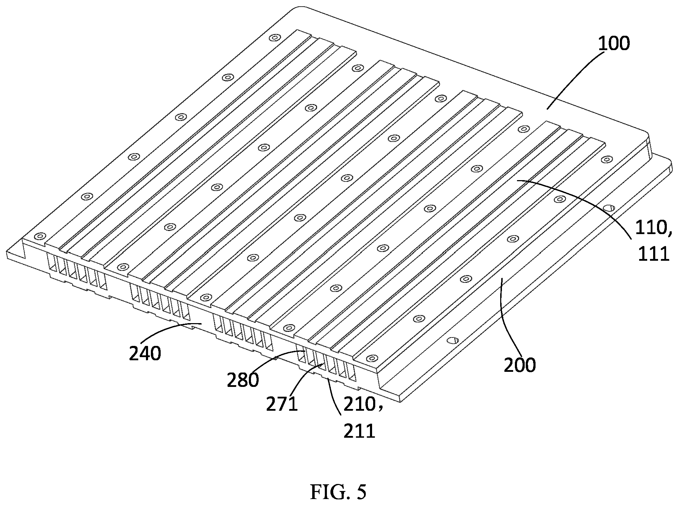

In some embodiments, particularly referring to FIG. 4 and FIG. 5, a plurality of bottom rib groups 210 are arranged on a lower surface of the base plate 240, wherein a number of the bottom rib groups 210 is equal to a number of the sub-flow channels 271, and the plurality of bottom rib groups 210 are arranged in one-to-one correspondence with the plurality of sub-flow channels 271 in a thickness direction of the base plate 240.

By arranging the bottom rib groups 210 on the lower surface of the base plate 240, precise contact is facilitated between the base plate 240 and the chip strip groups disposed on an upper surface of a lower hash board which is in contact therewith. The number of bottom rib groups 210 may be equal to the number of chip strip groups on the lower hash board. Furthermore, in a case where the number of bottom ribs 211 within each of the bottom rib groups is M, the number of chip strips within the chip strip group may also be M. In a case where the base plate 240 is brought into contact with the lower hash board, contact in one-to-one correspondence is achieved between the bottom ribs 211 and the chip strips. Furthermore, by configuring the number of bottom rib groups 210 to be equal to the number of sub-flow channels 271, and by arranging the plurality of bottom rib groups 210 to be in one-to-one correspondence with the plurality of sub-flow channels in the thickness direction of the base plate 240, it is ensured that each of the bottom rib groups 210 has a sub-flow channel that is in positional correspondence therewith. In this manner, heat generated by the chip strip groups of the lower hash board during operation is conducted through the correspondingly contacted bottom rib groups 210. Along this path, the heat is transferred more rapidly and directly into the respective sub-flow channels and is finally absorbed by the coolant, thereby significantly improving the heat dissipation efficiency.

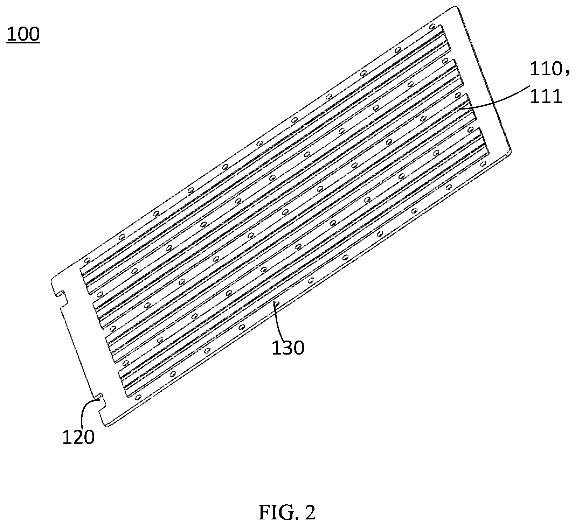

In some embodiments, particularly referring to FIG. 2 and FIG. 5, a plurality of top rib groups 110 are arranged on an upper surface of the top plate 100, wherein a number of the top rib groups 110 is equal to the number of the sub-flow channels 271, and the plurality of top rib groups 110 are arranged in one-to-one correspondence with the plurality of sub-flow channels 271 in a thickness direction of the top plate 100.

By arranging the top rib groups 110 on the upper surface of the top plate 100, precise contact is facilitated between the top plate 100 and the chip strip groups disposed on a lower surface of an upper hash board which is in contact therewith. The number of top rib groups 110 may be equal to the number of chip strip groups on the upper hash board. Furthermore, in a case where the number of top ribs within each of the top rib groups is N, the number of chip strips within the chip strip group may also be N. In a case where the top plate 100 is brought into contact with the upper hash board, contact in one-to-one correspondence is achieved between the top ribs and the chip strips. Furthermore, by configuring the number of top rib groups 110 to be equal to the number of sub-flow channels 271, and by arranging the plurality of top rib groups 110 to be in one-to-one correspondence with the plurality of sub-flow channels 271 in the thickness direction of the top plate 100, it is ensured that each of the top rib groups 110 has a sub-flow channel 271 that is in positional correspondence therewith. In this manner, heat generated by the chip strip groups of the upper hash board during operation is conducted through the correspondingly contacted top rib groups 110. Along this path, the heat is transferred more rapidly and directly into the respective sub-flow channels 271 and is finally absorbed by the coolant, thereby significantly improving the heat dissipation efficiency.

In some embodiments, particularly referring to FIG. 5, each of the bottom rib groups 210 and each of the top rib groups 110 both include three ribs.

In each of the bottom rib groups 210 and each of the top rib groups 110, spacings between adjacent ribs are equal, and a maximum distance between two ribs that are farthest apart is equal to a width of the sub-flow channel 271 corresponding to a rib group of the two ribs.

Taking a left-to-right arrangement of the ribs as an example, within each of the rib groups, the maximum distance between two ribs that are farthest apart is typically a distance from the leftmost edge of the leftmost rib to the rightmost edge of the rightmost rib. This distance typically defines a width of the rib group. With the above configuration, it is possible to make the width of each of the rib groups equal to the width of the sub-flow channel 271 correspondingly arranged therewith. In this way, the coolant within the sub-flow channel 271 flows to fully cover the area corresponding to the rib group. This allows the liquid cooling assembly to achieve more thorough heat dissipation for the chip strips of the upper hash board and lower hash board in contact therewith.

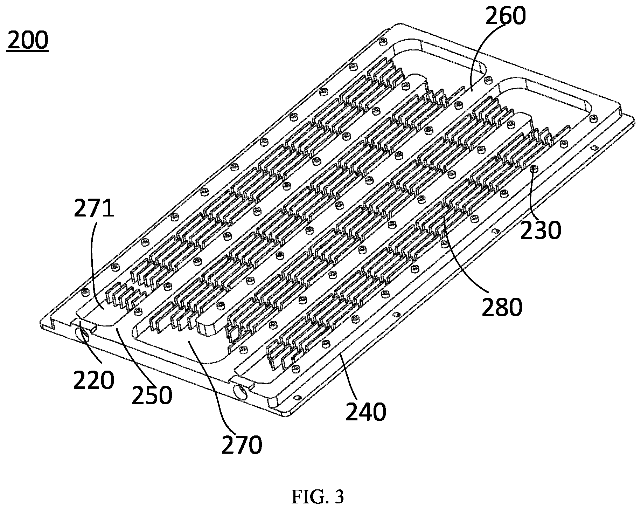

In some embodiments, particularly referring to FIG. 3, a number of the sub-flow channels 271 is four; and in each of the sub-flow channels 271, five rows of heat dissipation fins 280 are arranged, wherein the five rows extend in a same direction as an extension direction of the sub-flow channel 271.

The above configuration may result in lower flow resistance for the coolant within the flow channel 270, thereby fully ensuring the liquid cooling effect for the hash board in contact with the liquid cooling assembly. Moreover, under these conditions, the hash board may be configured with three chip strips at locations corresponding to the sub-flow channels 271. This correspondence in quantity allows for a uniform heat dissipation effect on the chip strips, thereby maintaining the temperature of the chip strips as consistent as possible.

In some embodiments, within each of the sub-flow channels 271, a plurality of heat dissipation fin groups are spaced apart along an extension direction of the sub-flow channel 271.

By arranging the heat dissipation fins 280 within each of the sub-flow channels 271 in spaced-apart groups, turbulence generated during flow of the coolant is effectively prevented. Turbulence often leads to bubbles, and the present disclosure, with the above configuration, significantly avoids the reduction in heat dissipation efficiency at locations where bubbles may occur.

In some embodiments, particularly referring to FIG. 1 to FIG. 4, at least one positioning structure is arranged between an upper surface of the sidewall 250 and the top plate 100 to accurately position the top plate 100 at a corresponding position on the upper surface of the sidewall 250.

The positioning structure includes two positioning protrusions 220 disposed on the upper surface of the sidewall 250 and two positioning slots 120 disposed at corresponding portions of the top plate 100.

Considering the need for rapid assembly of the top plate 100, the present disclosure provides a positioning structure between the upper surface of the sidewall 250 of the bottom shell 200 and the top plate 100, thereby enabling the top plate 100 to be quickly and accurately positioned and mounted onto the corresponding position on the bottom shell 200. By designing the positioning structure to include two positioning protrusions 220 disposed on the upper surface of the sidewall 250 and two positioning slots 120 disposed at corresponding portions of the top plate 100, a good positioning effect is achieved with a simple structure, which also facilitates manufacturing.

In some embodiments, particularly referring to FIG. 3, the base plate 240 is elongated, the sidewall 250 includes two short-side sub-sidewalls and two long-side sub-sidewalls, and both of the positioning protrusions 220 are disposed on an upper surface of a same one of the short-side sub-sidewalls.

In this case, it is evident that two positioning slots 120 corresponding to two positioning protrusions 220 are also disposed on the same short edge of the top plate 100. This facilitates manufacturing of the two positioning slots 120 and the two positioning protrusions 220, and also facilitates the rapid mounting of the top plate 100. This is because the positioning of the top plate 100 may be achieved simply by aligning the edge of the top plate 100 where the two positioning slots 120 are disposed with the specific sidewall of the bottom shell 200 on which the two positioning protrusions 220 are provided.

In some embodiments, particularly referring to FIG. 2 and FIG. 3, the at least one flow channel dividing wall 260 is juxtaposed with the long-side sub-sidewalls.

The positioning structure further includes positioning posts 230 and positioning holes 130, wherein the positioning posts 230 are arranged on both an upper surface of each of the flow channel dividing walls 260 and on an upper surface of each of the long-side sub-sidewalls, and positioning holes 130 corresponding to the positioning posts 230 are arranged in the top plate 100.

With the above configuration, the positioning effect between the top plate 100 and the bottom shell 200 is further enhanced. Moreover, the positioning structure, which achieves positioning through the positioning posts 230 and the positioning holes 130, has a simple structure and is easy to manufacture, and also facilitates smooth assembly between the top plate and the bottom shell.

In some embodiments, a plurality of the flow channel dividing walls 260 are parallelly arranged, and the plurality of sub-flow channels 271 are parallel to each other and sequentially communicated with each other.

With the above configuration, the coolant may be guided in parallel, and a flow direction of the coolant is clear and regular, which also facilitates the manufacturing of the bottom shell 200. Furthermore, the arrangement of the sub-flow channels 271 also achieves a more predictable heat dissipation effect, thereby facilitating the design of the liquid cooling assembly.

In some embodiments, a number of the chip strip groups is equal to the number of the sub-flow channels 271, and each of the chip strip groups includes three chip strips.

During use of the liquid cooling assembly in the supercomputing server, the chip strips are in contact with bottom ribs on the base plate 240 in one-to-one correspondence, or are in contact with top ribs on the top plate 100 in one-to-one correspondence.

With the above configuration, heat generated by the chip strips of the hash board during operation is rapidly and smoothly conducted through the bottom ribs or the top ribs in contact therewith into the interior of the liquid cooling assembly, and is finally absorbed by the coolant. In this way, the heat dissipation efficiency is further enhanced for the hash board.

Some embodiments of the present disclosure provide a computing and liquid cooling unit. The computing and liquid cooling unit includes a hash board and the liquid cooling assembly as described above, wherein the hash board is disposed on an upper surface of the top plate, and/or on a lower surface of the base plate.

Some embodiments of the present disclosure provide a supercomputing server. The supercomputing server includes the liquid cooling assembly as described above, or the computing and liquid cooling unit as described above.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A liquid cooling assembly, applicable to a supercomputing server, the supercomputing server comprising a hash board and the liquid cooling assembly, the hash board comprising a plurality of chip strip groups; wherein the liquid cooling assembly comprises a bottom shell (200) and a top plate (100); wherein
the bottom shell (200) comprises a base plate (240), a sidewall (250), at least one flow channel dividing wall (260), and a plurality of heat dissipation fins (280); wherein
the sidewall (250) is disposed on an upper surface of the base plate (240) and is arranged in an annular shape, forming a flow channel (270) for a coolant within the annular shape,
the at least one flow channel dividing wall (260) is disposed within the sidewall (250), wherein one end of the flow channel dividing wall (260) is connected to the sidewall (250) and another end of the flow channel dividing wall (260) is not in contact with any part of the sidewall (250), and the flow channel dividing wall (260) divides the flow channel (270) into a plurality of communicated sub-flow channels (271),
the plurality of heat dissipation fins (280) are distributed within each of the sub-flow channels (271), and
the base plate (240), the sidewall (250), the flow channel dividing wall (260), and the heat dissipation fins (280) are integrally formed; and
the top plate (100) is fitted onto an upper surface of the sidewall (250) facing away from the base plate (240), completely enclosing the flow channel (270), and a surface of each of the heat dissipation fins (280) facing away from the base plate (240) is in contact with the top plate (100);
wherein in a case where the liquid cooling assembly is applied in the supercomputing server, the hash board is disposed in contact with the base plate (240) or the top plate (100) of the liquid cooling assembly, and positions of the plurality of chip strip groups on the hash board are in correspondence with a region where the flow channel (270) is disposed within the liquid cooling assembly.

2. The assembly according to claim 1, wherein a plurality of bottom rib groups (210) are arranged on a lower surface of the base plate (240), wherein a number of the bottom rib groups (210) is equal to a number of the sub-flow channels (271), and the plurality of bottom rib groups (210) are arranged in one-to-one correspondence with the plurality of sub-flow channels (271) in a thickness direction of the base plate (240).

3. The assembly according to claim 2, wherein a plurality of top rib groups (110) are arranged on an upper surface of the top plate (100), wherein a number of the top rib groups (110) is equal to the number of the sub-flow channels (271), and the plurality of top rib groups (110) are arranged in one-to-one correspondence with the plurality of sub-flow channels (271) in a thickness direction of the top plate (100).

4. The assembly according to claim 3, wherein each of the bottom rib groups (210) and each of the top rib groups (110) both comprise three ribs; and
in each of the bottom rib groups (210) and each of the top rib groups (110), spacings between adjacent ribs are equal, and a maximum distance between two ribs that are farthest apart is equal to a width of the sub-flow channel (271) corresponding to a rib group of the two ribs.

5. The assembly according to claim 1, wherein a number of the sub-flow channels (271) is four; and in each of the sub-flow channels (271), five rows of heat dissipation fins (280) are arranged, the five rows extending in a same direction as an extension direction of the sub-flow channel (271).

6. The assembly according to claim 1, wherein within each of the sub-flow channels (271), a plurality of heat dissipation fin groups are spaced apart along an extension direction of the sub-flow channel (271).

7. The assembly according to claim 1, wherein at least one positioning structure is arranged between an upper surface of the sidewall (250) and the top plate (100) to accurately position the top plate (100) at a corresponding position on the upper surface of the sidewall (250);
wherein the positioning structure comprises two positioning protrusions (220) disposed on the upper surface of the sidewall (250) and two positioning slots (120) disposed at corresponding portions of the top plate (100).

8. The assembly according to claim 7, wherein the base plate (240) is elongated, the sidewall (250) comprises two short-side sub-sidewalls and two long-side sub-sidewalls, and both of the positioning protrusions (220) are disposed on an upper surface of a same one of the short-side sub-sidewalls.

9. The assembly according to claim 8, wherein the at least one flow channel dividing walls (260) is juxtaposed with the long-side sub-sidewalls; and
the positioning structure further comprises positioning posts (230) and positioning holes (130), wherein the positioning posts (230) are arranged on both an upper surface of each of the at least one flow channel dividing wall (260) and on an upper surface of each of the long-side sub-sidewalls, and positioning holes (130) corresponding to the positioning posts (230) are arranged in the top plate (100).

10. The assembly according to claim 1, wherein a plurality of the flow channel dividing walls (260) are parallelly arranged, and the plurality of sub-flow channels (271) are parallel to each other and sequentially communicated with each other.

11. The assembly according to claim 4, wherein a number of the chip strip groups is equal to the number of the sub-flow channels (271), and each of the chip strip groups comprises three chip strips;
wherein during use of the liquid cooling assembly in the supercomputing server, the chip strips are in contact with bottom ribs on the base plate (240) in one-to-one correspondence, or are in contact with top ribs on the top plate (100) in one-to-one correspondence.

12. A computing and liquid cooling unit, comprising: a hash board and the liquid cooling assembly as defined in any one of claims 1 to 11, wherein the hash board is disposed on an upper surface of the top plate, and/or on a lower surface of the base plate.

13. A supercomputing server, comprising: the liquid cooling assembly as defined in any one of claims 1 to 11, or the computing and liquid cooling unit as defined in claim 12.
